(19) Europäisches Patentamt
European Patent Office
Office européen des brevets

(11) Publication number: 0 081 956
B1

# (12) EUROPEAN PATENT SPECIFICATION

(45) Date of publication of patent specification: 17.09.86

(51) Int. Cl.[4]: H 01 S 3/19, H 01 S 3/06

(21) Application number: 82306438.1

(22) Date of filing: 03.12.82

## (54) Injection lasers with intergral waveguides.

(30) Priority: 03.12.81 US 327136

(43) Date of publication of application:
22.06.83 Bulletin 83/25

(45) Publication of the grant of the patent:
17.09.86 Bulletin 86/38

(84) Designated Contracting States:
DE FR GB

(56) References cited:
EP-A-0 031 808
US-A-3 978 426

PATENTS ABSTRACTS OF JAPAN, vol. 5, no. 103(E-64)775r, 3rd July 1981;
XEROX DISCLOSURE JOURNAL, vol. 4, no. 5, September/October 1979, page 637, New York (USA); R.D. BURNHAM et al.: "Prevention of optical facet damage in semiconductor lasers"

(73) Proprietor: XEROX CORPORATION
Xerox Square - 020
Rochester New York 14644 (US)

(72) Inventor: Burnham, Robert D.
2912 South Court
Palo Alto California 94306 (US)
Inventor: Scifres, Donald R.
1337 Montclair Way
Los Altos California 94022 (US)
Inventor: Streifer, William
263 Fairfield Court
Palo Alto California 94306 (US)

(74) Representative: Weatherald, Keith Baynes et al
European Patent Attorney Rank Xerox Limited
Patent Department 338 Euston Road
London NW1 3BH (GB)

EP 0 081 956 B1

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to injection semiconductor lasers and in particular to such lasers with integral quantum size effect transparent waveguiding in the active layer. These lasers may be of the quantum well type.

Quantum well heterostructure (QWH) lasers have attracted a large amount of interest in recent years because of the belief that quantum effects in the active regions of these lasers will provide improved operating characteristics in these lasers over the conventional double heterostructure injection lasers.

A QWH laser basically comprises a heterostructure device with an active region comprising a single layer or multiple layers comprising a series of very thin heterostructure alternating layers of materials having different bandgaps and refractive indices. In the case of GaAs/GaAlAs injection lasers, the quantum well active region comprises multiple alternate layers of $Al_xGa_{1-x}As$ and GaAs. In these heterostructures, the $Al_xGa_{1-x}As$ layers (where x may be approximately 0.3 to 1.0) forms coupling barriers in the active region whereas the GaAs layers form wells. As an example, the size or thickness, $L_B$, of the barriers may be about 1 to 5 nm while the size or thickness, $L_Z$, of the wells may be about 3 to 5 nm where $L_B$ and $L_Z$ are generally equal to or less than 5 nm but may be greater or less compared to one another.

The advantage of these quantum well lasers is by confining the carriers (holes and electrons) to very thin active layers, the energy level of the lowest energy states will be modified and raised to one or more steps above the band edge, i.e., will shift the lowest confined carrier transitions E, more above the energy gap $E_g$.

Recently, it has been demonstrated that phonon (LO) assistance is present in this state transition so that carriers have additional states to transfer to before recombining and producing radiation. These additional lower energy states are believed to be important in the radiation recombination emission from the QWH laser. Said in simpler terms, a phonon (LO) transition can assist in the recombination mechanism to make an indirect bandgap situation due to material difference function more like a direct bandgap phenomenon.

Thus, QWH mechanism provides phonon assisted radiative recombination to scatter carriers (electrons) to lower energies before recombining to provide photons and stimulated lasing action. For background, see the articles of R. Dingle et al, "Quantum States of Confined Carriers in Very Thin $Al_xGa_{1-x}As$-GaAs-$Al_xGa_{1-x}As$ Heterostructures", *Physical Review Letters,* Vol. 33, No. 14 pp. 827—829 (September 30, 1974); R. D. Depuis et al, "Continuous 300 K Laser Operation of Single-Quantum-Well $Al_xGa_{1-x}As$-GaAs-Heterostructure Diodes Grown by Metalorganic Chemical Vapor Deposition", Vol. 34, No. 4 pp. 265—267 (February 15, 1979); N. Holonyak et al, "Phonon-Sideband MO-CVD Quantum-Well $Al_xGa_{1-x}As$-GaAs Heterostructure Laser", *Applied Physics Letters,* vol. 34, No. 8, pp. 502—505 (April 15, 1979); N. Holonyak et al, "Alloy Clustering in $Al_yGa_{1-x}As$-GaAs Quantum-Well Heterostructures, *Physical Review Letters,* Vol. 45 No. 21, pp. 1703—1706 (November 24, 1980); J. J. Coleman et al, "High-Barrier Cluster-Free $Al_xGa_{1-x}As$-AlAs-GaAs Quantum-Well Heterostructure Laser", *Applied Physics Letters,* Vol. 38. No. 2 pp. 63—65 (January 15, 1981); and W. T. Tsang, "Device Characteristics of (AlGa)As Multi-Quantum Well Heterostructure Lasers Grown by Molecular Beam Epitaxy".

There also has been interest in fabricating injection lasers that have active regions that couple into transparent waveguide structures in the device. Some of the reasons for this interest is to provide integral waveguides that are non-absorbing to propagating radiation for efficient radiation coupling to other optical passive devices, to permit the spreading of radiation into the passive waveguide region which minimizes beam divergence and to confine laser pumped active regions away from the laser mirror facets to reduce facet degradation. Examples of this concept are disclosed in the paper of H. O. Yonezu et al entitled "An AlGaAs Window Structure Laser", *IEEE Journal of Quantum Electronics,* Vol. QE-15, No. 8, pp 775—781, August, 1979 and the *Xerox Disclosure Journal,* Vol. 4, No. 5, p 637 (September/October, 1979). This concept has been suggested for integration into the strip buried heterostructure laser [R. L. Hartman et al, "The CW Electro-Optical Properties of (Al,Ga)As Modified-Strip Buried Heterostructure Lasers", *Journal of Applied Physics,* Vol. 51, No. 4, pp. 1909—1918, April 1980].

The conventional taper coupler is shown in the above-mentioned *Xerox Disclosure Journal.* In that structure, the active region of p-GaAs may be formed on the transparent waveguide layer of n-$Ga_{.9}Al_{.1}As$ by masking techniques.

Although the concept of taper coupling the active region into a transparent waveguide in such laser devices appears to be a most attractive technique for effective and efficient coupling between such an active region and a passive region or waveguide, there are several disadvantages. First, in the fabricating of such a laser device, it is necessary in the process, whether it be molecular beam epitaxy (MBE) or metalorganic chemical vapor deposition (MO-CVD), to introduce into the chamber or reactor the aperture mask to produce the active region midway through growth. This introduces contamination, which seriously effects the GaAlAs-GaAs interface. Aluminum is very reactive to oxygen and will combine with the exposed transparent waveguide layer, providing defects.

Secondly, while the n-type $Ga_{.9}Al_{.1}As$ layer is a wider gap material than the p-type active region to serve as an efficient transparent waveguide and has some doping concentration in order to supply current to the active region, free carrier absorption in these transparent regions could be minimized if this waveguide layer were undoped or doped very lightly.

Third, the n-type transparent waveguide layer does not confine the injected carriers (holes) as desired because of the reduced potential barrier height. As a result, the laser current threshold will vary more rapidly with temperature variations.

The laser structures disclosed herein reduce or eliminate these disadvantages in the conventional tapered coupler heterostructure injection laser.

According to the present invention the wider bandgap transparent waveguide layer may be eliminated from conventional tapered coupler heterostructure lasers and providing an active layer in the regions where transparency is desired having an extremely small thickness (e.g., below 50 nm) so that quantized electron states are produced in the conduction and hole states in the valence band. The active region of the active layer is thicker and is coupled into the thin active layer regions. The active region permits carrier recombination under lasing conditions for supporting propagation in an optical cavity that includes the very thin active layer regions that appear transparent to the propagating radiation. The transparency occurs because the active layer in these regions is so thin that the band structure is changed because of the quantum size effect. When the electron states are quantized, radiation produced in the thicker active region will not be absorbed in the thinner active layer because of band structure change.

Other objects and attainments together with a fuller understanding of the invention will become apparent and appreciated by referring to the following description and claims taken in conjunction with the accompanying drawings, in which:

Figure 1 is a schematic side view of a heterostructure injection laser in accordance with the prior art;

Figure 2 is a schematic side view of a heterostructure injection laser in accordance with this invention;

Figure 3 is a schematic side view of another embodiment of a heterostructure injection laser in accordance with this invention;

Figure 4 is a schematic side view of a still further embodiment of a heterostructure injection laser in accordance with this invention; and

Figure 5 is a schematic side view of a modified form of the active region of the injection laser shown in Figure 4.

Reference is first made to Figure 1 which discloses a conventional tapered coupler heterostructure injection laser 10 previously referenced and known in the art.

Laser 10 comprises a plurality of consecutively deposited semiconductor layers, for example, of GaAs and GaAlAs of varying doping levels, thicknesses and composition. Substrate 12 may be n-GaAs. Cladding layer 14 is n-$Ga_{1-x}Al_xAs$ (e.g., x=.4), transparent or passive layer 16n-$Ga_{1-y}Aly_yAs$ (e.g., y=.1), active region 18 p, n or undoped GaAs, cladding layer 20 of p-$Ga_{1-x}Al_xAs$ (e.g., x=.4) and contact layer 22 of p or $p^+$-GaAs. The tapered couplers 19 couple radiation produced in the active region 18 into the wider bandgap waveguide layer 16. The metal contact 24 on layer 22 only covers the region to be pumped, i.e., the active region 18. The bottom equalization 26 comprises the other electrode. No radiative recombination will occur because of current injection in the regions of the waveguide layer 16 beyond the active region 18 thereby reducing undesirable erosion and degradation at the end facet 28. However, there are the disadvantages as previously alluded to relative to use of wider bandgap transparent waveguide layer 16. These disadvantages are overcome by the injection laser structures of Figures 2—5.

In Figure 2, the heterostructure injection laser 30 comprises the substrate 32 upon which is consecutively deposited by a selected fabricating process (e.g., MBE or MO-CVD) the cladding layer 34 of n-$Ga_{1-x}Al_yAs$, the active layer 36 with the active region 38 of undoped or very slightly doped (e.g., $3\times10^{17}$) quality, the cladding layer 41 of p-$Ga_{1-x}Al_xAs$ and the contact layer 40 of $P^+$-GaAs. The appropriate metal contacts 42 and 44 are provided for forward biasing laser 30. Ion or proton implanted regions 46 may be provided for current confinement enhancement. Upon forward biasing of laser 30, carrier recombination occurs in active region 38 and radiation induced in this region is taper coupled at 39 into the thin active layer regions 47 of the active layer 36. Thus, an optical cavity is established between end facets 48 for the propagating radiation.

The primary difference between injection laser 30 and injection laser 10 is that the active regions 47 are extremely thin, i.e., they are sufficiently thin to provide the quantization of electron states so that radiative recombination cannot occur. The thin regions 47 form a quantum well. They raise the effective band edge of the crystal so that an electron is not permitted to transfer to the bottom of the well but can stay only in some higher energy state. The radiation produced in the active region will couple into the thin regions 47 because, even though this coupling may be somewhat weak, regions 47 have still the highest index of refraction, next to region 38. The coupled radiation in regions 47 experiences transparency because of band structure change caused by the quantum size effect. When the electron states are quantized, radiation produced in the active region 38 will not be absorbed in the thinner quantum well regions 47 because of the band structure change. The energy state in the quantum well regions 47 is not sufficient to cause any excitation to the propagating radiation. As a result, there will be no radiation absorption in regions 47.

The preferred thickness of the active region 38 may be approximately 50 to 10,000 nm while the thickness of the quantum well regions 47 may be approximately 0.5 to 50 nm preferably about 5 to 20 nm. The molar fraction, x, for example, may be approximately 0.3 to 1.0.

While only the side view of laser structure is being shown for the purposes of illustrating the invention, it should be noted that it is intended that the active layer 36 may be two-dimensional i.e., regions 38 and 47 extend for the full width of the laser device, or three-dimensional i.e., regions 38 and 47 comprise a strip completely confined on all sides by wider bandgap material.

The epitaxial growth procedure for laser 30, as well as other lasers to be discussed, is as follows for the two-dimensional version. Epitaxial growth proceeds up to and including a very thin active layer. For example, in MO-CVD processing, and after deposition of layer 34, a very thin layer of about 5 nm of undoped GaAs is deposited on layer 34. Next, a mask having an elongated aperture is positioned on the thin active layer and the growth of layer 36 is continued. The mask is provided with an inner channel or chamber so that while the epitaxal deposition of region 38 proceeds, the tapered coupler regions 39 are formed due to the mask aperture geometry. During the growth of layer 36, the aluminum-containing layer 34 is not contaminated because it is protected by previously deposited 5 nm thin GaAs layer.

For laser structures of three-dimensional type the epitaxial growth procedure may be followed. The thin initially grown active layer may have a thickness of about 40 nm. Continued growth of the active layer is achieved as previously explained until an active region 38 of about 100 nm in thickness is produced. The active strip is formed by selective etching.

Laser 50 in Figure 3 is identical to laser 30 in Figure 2 except for the additional transparent waveguide layer 52. Layer 52 is lightly doped ($3\times10^{17}$) and may be comprised of n-$Ga_{1-y}Al_yAs$. Layer 52 functions also as a transparent waveguide to the propagating radiation. Layer 52 provides for taper coupling into a large transparent waveguide comprising the combination of regions 47 and layer 52 for enhanced waveguiding and low beam divergence.

An alternative to the inclusion of waveguiding layer 52 would be to provide a transverse graded doping profile through cladding layer 34 so that the upper regions of this layer have a lighter doping profile as compared to its lower regions.

The injection laser according to this invention may also have an active layer comprising of multiple quantum well passive regions. In Figure 4, the laser 60 is identical to laser 30 in Figure 2 except for the quantum well structure in active layer 36 comprising alternating layers 36.1 of undoped GaAs/$Ga_{1-y}Al_yAs$. Layers 36.1 may, for example, be each about 4 to 5 nm thick. Regions 47 comprise multiquantum well unpumped regions while the combination of active region 38 and the adjacent multiquantum well region 47.1 are pumped to provide carrier recombination under lasing conditions. In Figure 5, the active region of laser 60 has been modified to comprise alternating layers 38.1 of undoped GaAs/GaAlAs, which together with region 47.1 form the active cavity region for laser 60. The quantum well layers 38 in the active region 38 preferably have a little larger thickness (e.g., 5 nm) compared to layers 36.1 (e.g., 4 nm) to ensure that the waveguide regions 47 are more transparent to the propagating radiation.

In order to guard against any wave leakage of the propagating radiation in the lasers according to this invention, it is important that there is symmetry in the refractive index of cladding layers 34 and 41. A 3% or more difference in the refractive index in these layers may force the wave out of the thin waveguiding regions 47. This would not be so much of a problem for laser 50 since the transparent waveguide is much thicker. In matching the index of the layers, both the Al content and doping concentration must be taken into consideration since they are of different conductivity type.

Other known composition/alloy systems may be used instead of GaAs/GaAlAs, for example, (GaIn)(AsP). DFB (distributed feedback) or DBR (distributed Bragg reflector) laser structures may be incorporated. The thin active region/quantum well active layer may be incorporated in curved lasers or waveguides or in laser arrays formed on a single substrate. Additional wider bandgap layers may be added to both sides of the thin active region/quantum well active layer to form a large optical cavity region. The large optical cavity region could be index graded so as to have a bandgap variation. The active region could be made very short. The periodic quantum well layers Figure 4 and 5 would be designed with specific composition and layer thickness to optimize current threshold and longitudinal and fundamental transverse modes of operation.

Also, the current conducting stripe contact 42 could alternatively extend to the facets 48 of the laser rather than terminate over the active region as shown in the figures.

## Claims

1. An injection laser comprising a plurality of contiguous semiconductor layers deposited on a substrate (32), one of said layers being an active layer (36) and having a lower bandgap and higher index of refraction relative to at least cladding layers (34, 41) immediately adjacent to said active layer, said active layer having an active region (38) to permit carrier recombination and support radiation propagating under lasing conditions in a cavity established between transverse end facets (48) of the laser, means (46) incorporated into said laser to confine current to said active region, characterised in that the extremities of the active region do not extend up to the end facets, so that the regions of the active layer between it and the end facets function as a passive waveguide for the propagating radiation, said passive waveguide regions of said active layer being sufficiently thin to form a quantum well waveguide so as not to be light absorbing because of the quantization of electron states.

2. An injection laser as claimed in claim 1, wherein said active region has a thickness in the range of 50 to 1000 nm, and said passive waveguide regions of said active layer have a thickness in the range of 0.1 to 50 nm.

3. The injection laser of claim 2, wherein said passive waveguide regions of said active layer have a preferred thickness in the range of 5 to 10 nm.

4. The injection laser as claimed in any preceding claim, in which a layer of waveguide material (52) is interposed between the active layer and one of the cladding layers, the material being substantially transparent to the propagating radiation.

**Patentansprüche**

1. Injektionslaser mit einer Vielzahl aneinander grenzender Halbleiterschichten, die auf ein Substrat (32) aufgebracht sind, wobei eine der Schichten eine aktive Schicht (36) ist und eine geringerere Bandlücke und einen größeren Brechungsindex in Bezug auf wenigstens unmittelbar der aktiven Schicht benachbarte Einhüllschichten hat (34, 41), wobei die aktive Schicht einen aktiven Bereich (38) aufweist, um eine Trägerrekombination zu erlauben und Strahlung zu unterstützen, die sich beim Aussenden von Laserstrahlen in einem zwischen querverlaufenden Endflächen (48) des Lasers gebildeten Hohlraum fortpflanzen, einer Einrichtung (46), die in dem Laser eingearbeitet ist, um Strom auf den aktiven Bereich zu begrenzen, dadurch gekennzeichnet, daß sich die Enden des aktiven Bereiches nicht bis zu den Endflächen erstrecken, so daß die Bereiche der aktiven Schicht zwischen ihm und den Endflächen als ein passiver Wellenleiter für die sich fortpflanzende Strahlung wirkt, wobei die passiven Wellenleiterbereiche der aktiven Schicht ausreichend dünn sind, um einen Quantentopf-Wellenleiter zu bilden, so daß er wegen der Quantisierung der Elektronenzustände nicht lichtabsorbierend ist.

2. Injectionslaser nach Anspruch 1, bei dem die aktive Schicht eine Dicke im Bereich von 50 bis 1000 nm besitzt und die passiven Wellenleiterbereich der aktiven Schicht eine Dicke im Bereich von 0,1 bis 50 nm besitzen.

3. Injectionslaser nach Anspruch 2, bei dem die passiven Wellenleiterbereiche der aktiven Schicht eine bevorzugte Dicke im Bereich von 5 bis 10 nm aufweisen.

4. Injektionslaser nach einem der vorhergehenden Ansprüche, bei dem eine Schicht aus Wellenleitermaterial (52) zwischen der aktiven Schicht und einer der Einhüllschichten eingefügt ist, wobei das Material für die sich fortpflanzende Strahlung im wesentlichen transparent ist.

**Revendications**

1. Laser à injection comportant une multitude de couches contiguës en semi-conducteur déposées sur un substrat (32), l'une des couches étant une couche active (36) et présentant un intervalle de bande plus faible et un indice de réfraction plus élevé par rapport au moins à des couches d'habillage (34, 41) immédiatement contiguës à la couche active, la couche active ayant une région active (38) pour permettre la recombinaison des porteurs et supporter le rayonnement se propageant dans les conditions de fonctionnement laser dans une cavité établie entre les facettes extrêmes transversale (48) du laser, un moyen (46) incorporé dans le laser pour confiner le courant à la région active caractérisé en ce que les extrémités de la région active ne s'étendent pas jusqu-aux facettes extrêmes, de sorte que les régions de la couche active entre elle et les facettes extrêmes fonctionnent en guide d'ondes passif pour le rayonnement se propageant, les régions à guide d'ondes passif de la couche active étant suffisamment fines pour former un guide d'ondes à puits quantique qui n'absorbe pas la lumière à cause de la quantification des états des électrons.

2. Laser à injection selon la revendication 1, dans lequel la région active a une épaisseur comprise entre 50 et 1000 nm, les régions passives du guide d'ondes de la couche active ont une épaisseur comprise entre 0,1 et 50 nm.

3. Laser à injection selon la revendication 2, dans lequel les régions passives du guide d'ondes de la couche active ont une épaisseur préférée comprise entre 5 et 10 nm.

4. Laser à injection selon l'une quelconque des revendications précédentes, dans lequel une couche du matériau (52) du guide d'ondes est interposée entre la couche active et l'une des couches d'habillage, le matériau étant sensiblement transparent vis-à-vis du rayonnement se propageant.

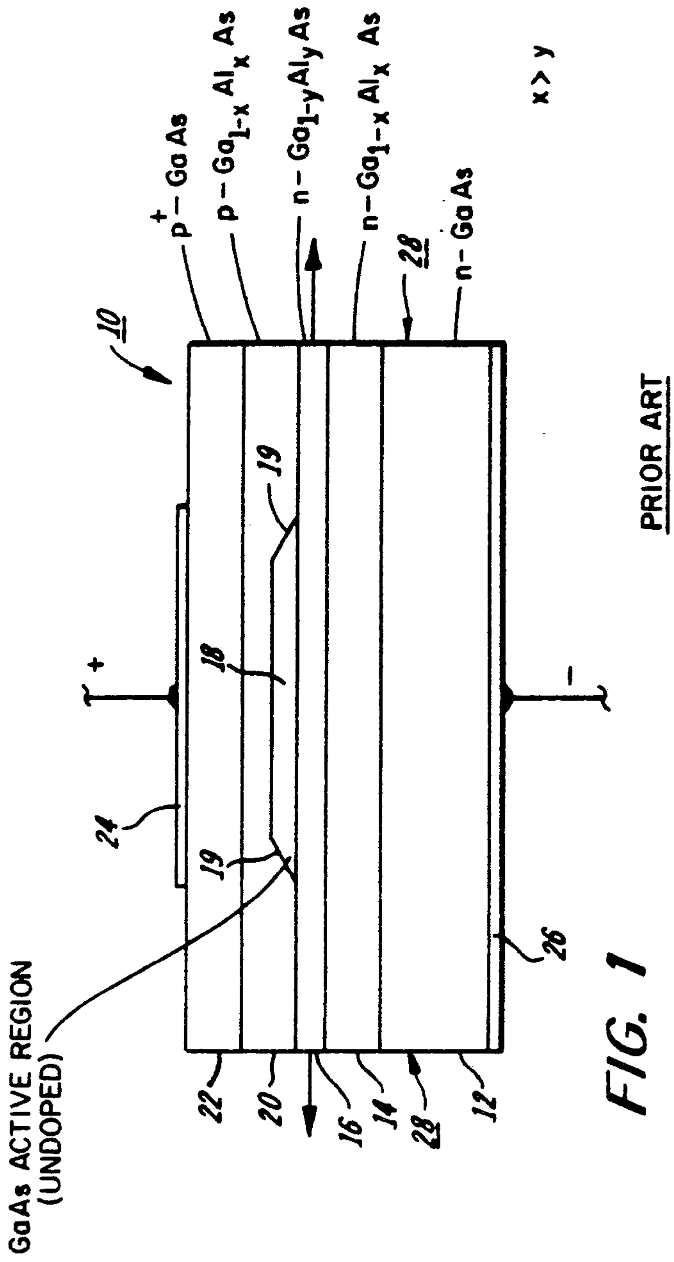


FIG. 1

PRIOR ART

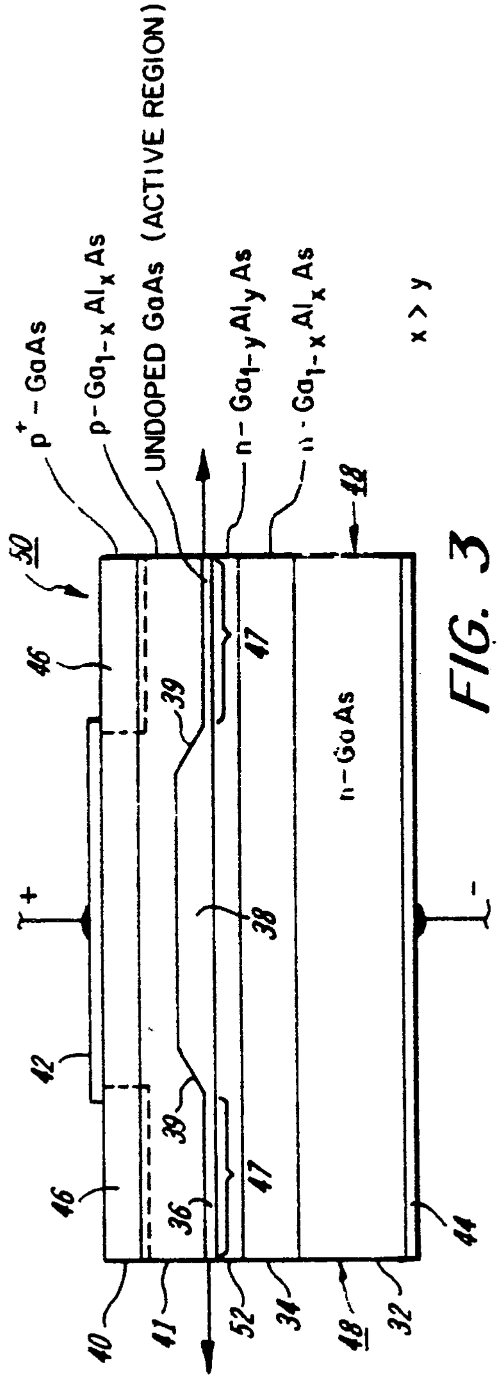

p⁺ - GaAs
p - Ga1-x Alx As
UNDOPED GaAs (ACTIVE REGION)
n - Ga1-y Aly As
n - Ga1-x Alx As
x > y
50
48
46
42
39
38
47
36
40
41
52
34
32
44
n-GaAs
+
-


FIG. 3

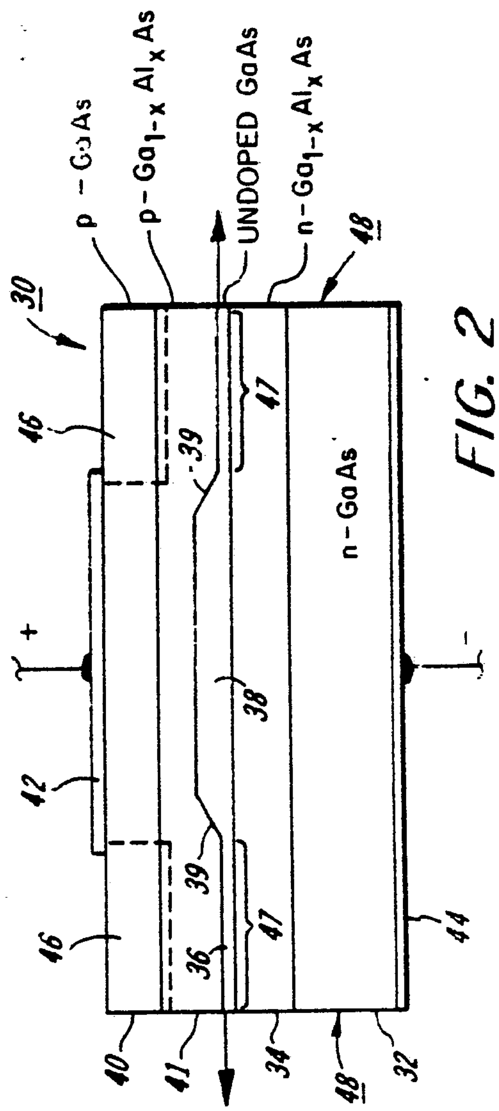

p - GaAs
p - Ga1-x Alx As
UNDOPED GaAs
n - Ga1-x Alx As
30
48
46
42
39
38
47
36
40
41
34
32
44
n-GaAs
+
-


FIG. 2

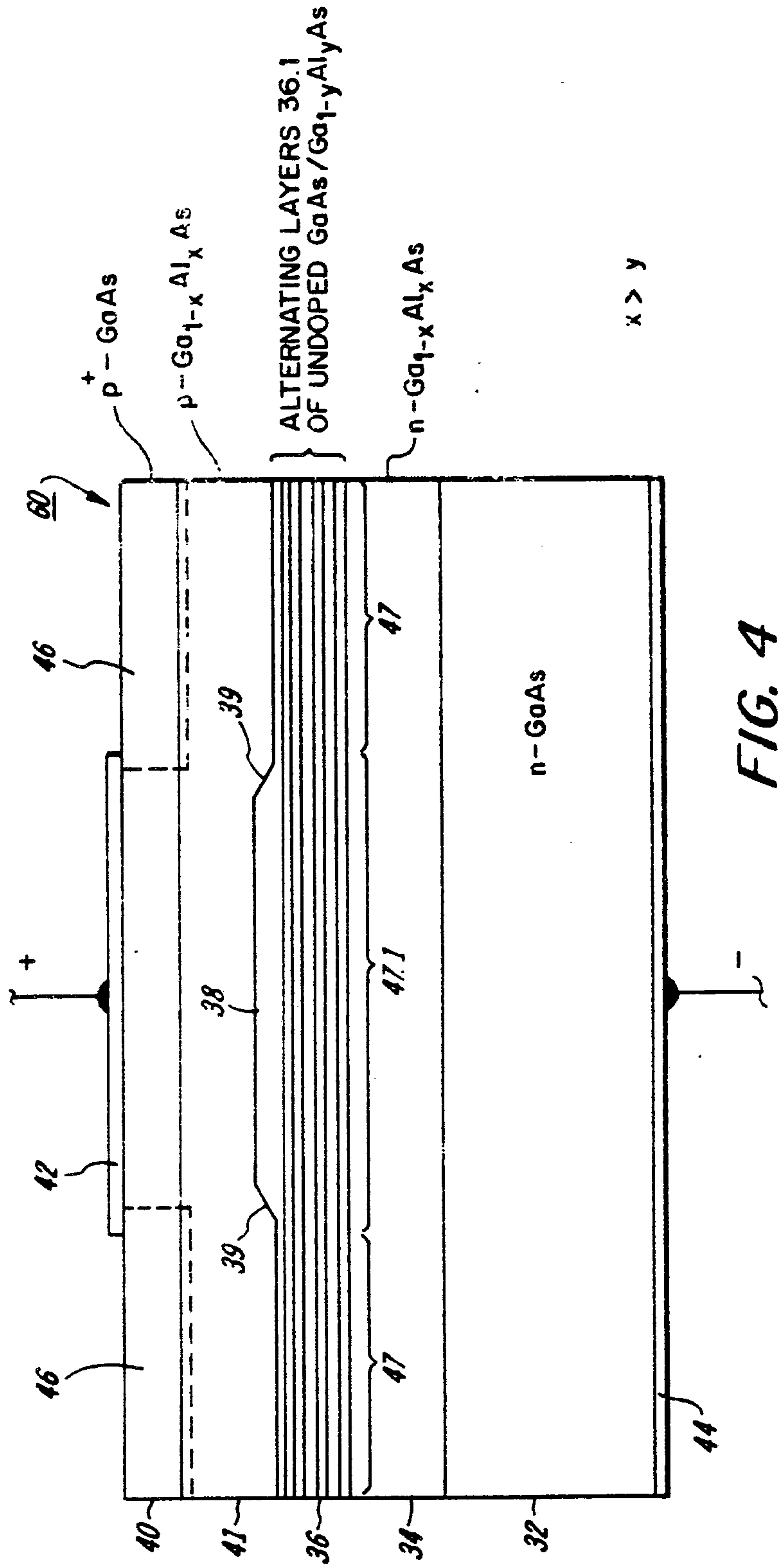
60
$p^+$ - GaAs
p - $Ga_{1-x}Al_xAs$
ALTERNATING LAYERS 36.1
OF UNDOPED GaAs/$Ga_{1-y}Al_yAs$
n - $Ga_{1-x}Al_xAs$
x > y
46
42
46
+
−
39
38
39
47
47.1
47
n - GaAs
44
40
41
36
34
32

FIG. 4

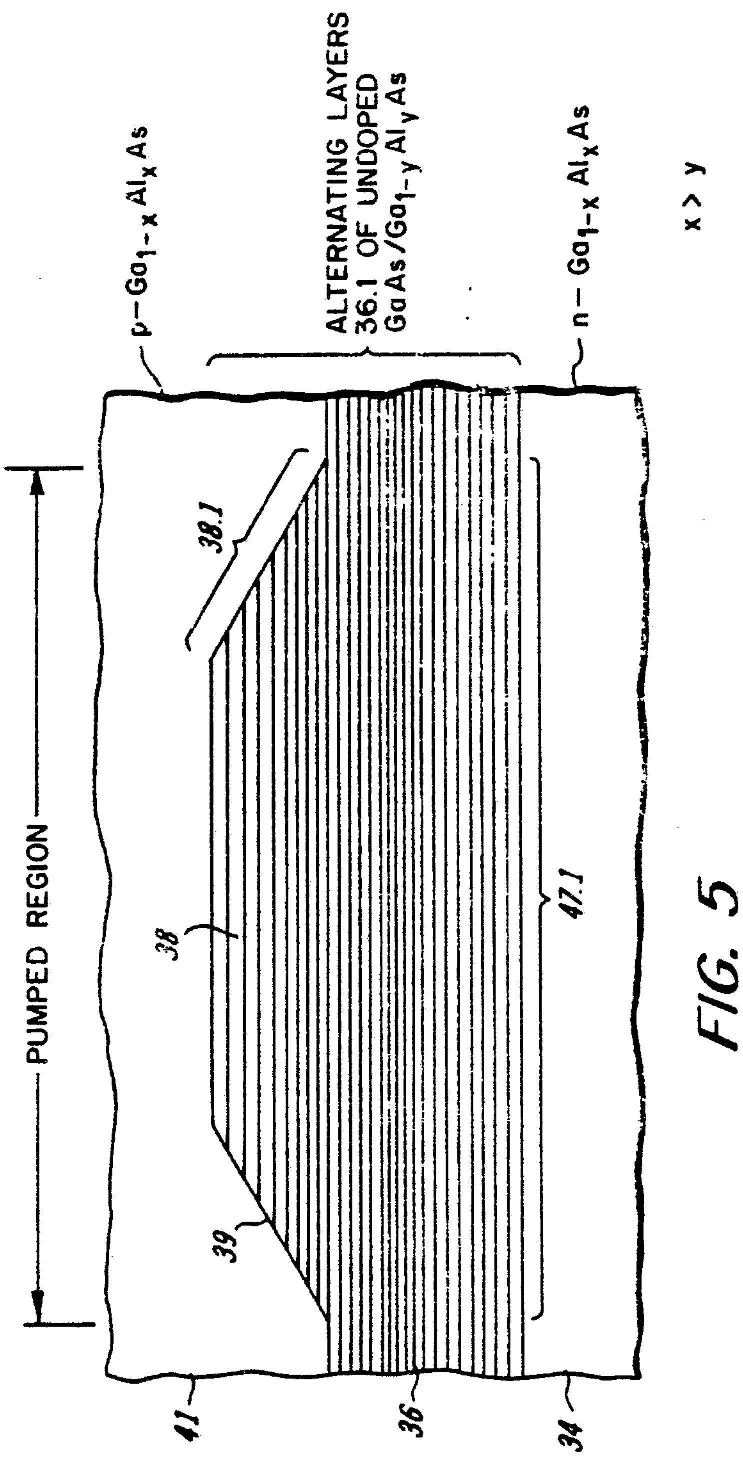

p−$Ga_{1-x}Al_xAs$
ALTERNATING LAYERS
36.1 OF UNDOPED
$GaAs/Ga_{1-y}Al_yAs$
n− $Ga_{1-x}Al_xAs$
x > y
PUMPED REGION
38.1
38
39
47.1
41
36
34


FIG. 5